# EUROPEAN PATENT SPECIFICATION

(11) **EP 2 018 563 B1**
(45) Date of publication and mention of the grant of the patent: **02.11.2011**
(21) Application number: 07735804.2
(22) Date of filing: 08.05.2007
(51) Int. Cl.: G01N 33/543, G01R 33/02, G01R 33/09, G01R 33/12

(54) **A magnetic system for biosensors**
Magnetisches System für Biosensoren
Système magnétique pour biocapteurs

(30) Priority: 10.05.2006 EP 06113768
(43) Date of publication of application: 28.01.2009
(73) Proprietor: Koninklijke Philips Electronics N.V., 5621 BA Eindhoven (NL)
(72) Inventor: VAN LANKVELT, Petrus Johnnes Wilhelmus, 5656 AA Eindhoven (NL)
(74) Representative: Van Velzen, Maaike Mathilde
(86) International application number: PCT/IB2007/051721
(87) International publication number: WO 2007/129279

(56) References cited:
- WO-A-01/40790
- DE-A1- 10 137 665
- EDELSTEIN R L ET AL: "THE BARC BIOSENSOR APPLIED TO THE DETECTION OF BIOLOGICAL WARFARE AGENTS" BIOSENSORS & BIOELECTRONICS, ELSEVIER SCIENCE PUBLISHERS, BARKING, GB, vol. 14, no. 10/11, January 2000 (2000-01), pages 805-813, XP001069427 ISSN: 0956-5663

## Description

The invention relates to a magnetic system for biosensors.

For the conditioning biomaterial in order to reach an effective evaluation of biomaterial components, the biomaterial has to be brought into a closer contact to the surface of the biosensor. Therefore an attracting force to the biomaterial must be generated. This is usually realised by magnetic beads, which will be chemically or physically bound to the biomaterial. A magnetic attraction force must be generated near the sensor surface.

Magnetic actuation is crucial for the operation of biosensors. Firstly, it speeds up the concentration and therefore the binding process of the magnetic particles at the sensor surface. Secondly, magnetic washing can replace the traditional wet washing step, which is more accurate and reduces the number of operating actions.

Compared to the chip dimensions, large external electro-magnets are used for actuation in order to achieve homogeneous field gradients at the sensor surface and large penetration depth over the entire sample volume. These qualities are hard to achieve with integrated actuation structures.

The used biosensors of biochips have promising properties for bio-molecular diagnostics in terms of sensitivity, specificity, integration, ease of use and costs.

Examples of such biochips are given in WO 2003054566, which describe excitation with uniform magnetic fields.

A biosensor is based on the detection of super-paramagnetic beads and may be used to simultaneously measure the concentration of a large number of different biological molecules in a solution of biomaterial.

So the sensor-surface must have a close contact to the biomaterial which can be caused, by bringing the biomaterial very close to the sensor surface with the help of the mentioned magnetic beads. The other side is that after measuring the biomaterial must be washed away, in order to condition the sensor surface for the next measurement.

This can also be realised with the magnetic beads mixed with the biomaterial, thus generating a magnetic repulsion force near the sensor surface.

Normally, a magnetic force induced by a magnet or a electromagnet is directed towards the magnet. Therefore, two magnets are needed for inducing a magnetic force towards the sensor surface, the so called sedimentation, and away from the sensor surface, the so called washing.

State of the art, R.L. Edelstein et al., Biosensors and Bioelectronics 14 (2000), 805- 813, discloses an electromagnetic assembly with a core for exerting forces at magnetic beads having a plunder which can be moved. With the plunder retracted from the magnetic field there is a homogenous magnetic field between the poles above and below, with the plunder extended in an area of the magnetic field the magnetic field changes to an inhomogeneous magnetic field. The density of magnetic field lines gets lower in a direction up and away from the surface of the core, reaches a minimum, and gets higher again in the same direction. There is constructional cost for the plunger and the control of the plunger. Furthermore, the direction of magnetic forces is restricted to forces directed to the core near to the core, and forces directed away from the core far from the core.

It is an object of the present invention, to provide a magnetic system with the aforesaid properties which can switch between attraction force and repulsion force near the sensor surface.

The stated object is achieved for a magnetic system for biosensors by characterizing features of patent claim 1.

Further embodiments of this magnetic system are **characterized in the** dependant claims 2 - 7.

The stated object is also achieved for operating a magnetic system for biosensors, by characterizing features of patent claim 8.

Further embodiments of this method are characterized in dependent claims 9 - 10. located, in order to produce a local high density of inhomogeneous magnetic field lines, along which the sensor is movable between at least two definable positions.

This invention considers a magnet which can do it both. Besides a normal attraction force, this magnet is also capable of applying a repulsive force.

Also, power consumption is a big issue in portable point-of-care applications. Therefore, it is important to maximize the force that can be generated with an electro-magnet. When the special magnet disclosed in this invention is used in combination with a normal magnet or electromagnet, the magnitude of the magnetic force can be increased substantially. It is also possible to create the same force at much lower currents compared to the situation in which only standard magnets are used.

So one of the essential features of the invention is the opening in the magnetic core, especially also the special shape of the opening. This causes a magnetic attraction force near the surface in a defined near distance and in a farer distance a repulsion force on the biomaterial conditioned with the magnetic beads. So it is essential to switch between the magnetic force directions by a single magnetic system, by changing the relative position between the magnet and the sensor surface.

An embodiment of the invention discloses an opening in the magnetic core which is a cylindrical blind hole, and another advantageous opening in the core is a cone-shaped hole or opening.

In both cases inhomogeneous magnetic field lines are induced, which cause in a defined distance region an attractive force and in another distance a repulsive force. It is essential to this invention that both force directions are given by only one magnetic core.

A further embodiment of the invention is that the sensor is movable between the inside and the outside of the opening. With other words, this means that the sensor can be driven in both force direction positions.

A further embodiment is that a second magnet is arranged adjacent to the magnet, which are separated over a gap, in which the position of the sensor, that means at least the sensor surface is movable. This special magnetic system is an intensifying magnetic system with high magnetic forces.

For the advantageous use for biosensors, an embodiment of the invention discloses that the sensor is an array of several sensors. This results in a very effective sensor with a big resulting sensor-active surface.

A further embodiment of the invention is that the definable end positions of the sensor movement can be optimized by a magnetic field sensor, which can be moved simultaneously with the sensor, in order to evaluate optimal extremes of the magnetic flux. By this, the magnetic forces generated near the sensor surface can be optimized in their strength in order to generate maximum magnetic force in attraction mode as well as in repulsion mode. This causes an intense contact to the biomaterial in sensing modus, as well as an optimal repulsion in washing modus.

A further object of the invention is a method which uses a magnetic system for biosensors as described, by which a sensing material or liquid is dispersed with or chemically bound to microscopic magnetic beads, and the sensor chip is moved in a close position to the opening in the magnetic core, in order to generate magnetic repulsion near the sensor surface area to wash the surface by repulsion forces of the magnetic beads, and the sensor chip is moved in a defined distance of the core in order to generate attraction forces to the magnetic beads for sensing the bio-substrate in a very close contact to the sensor surface.

By switching between the two distance positions, the sensor can be switched between optimized measuring modus and optimized washing modus.

An embodiment of the method is **characterized in that** the movement between sensor or sensor-chip and magnetic core is a relative movement, by which the core is moved in such a way that a first sensor position is out of the opening in the magnetic core, being in the influence of the attractive force area, and one sensor position is inside the opening of the magnetic core, in the influence of the repulsive force area.

This movement is relative, so moving the sensor chip or moving the coil with the magnet core results in the same relative position to each other.

A last embodiment of the method is **characterized in that** in a magnetic arrangement two magnets are separated by a gap, so that the relative position of the sensor is between the inside of the opening of one magnetic core and the inside of the gap between the two magnetic cores.

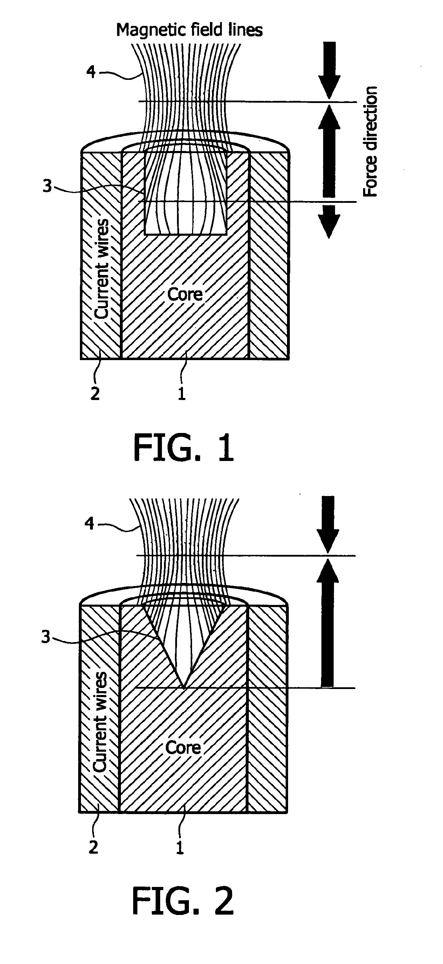

Different embodiments of the invention are shown in figure 1 to figure 5.
Figure 1 shows a first embodiment of the invention, by which the opening 3 in the magnetic core 1 is cylindrical. In contrast to a core without an opening, e.g. with a plane surface for the escape of magnetic field lines which can only cause attractive magnetic force, the cylindrical opening 3 causes such an inhomogeneous field, represented by the magnetic field lines 4, that in dependency to the distance from the bottom of the opening towards outwards the magnetic core, the effected magnetic force change its direction two times. So in dependency of the actual relative sensor positions, which can be changed mechanically, the sensor can be shifted into the attractive or into the repulsive force area of the field of the magnet system.
Figure 2 shows another embodiment, in which the opening 3 is cone-shaped. This special shape cause a field in which the magnetic force is strongly repulsive and another distance in which it is attractive.

This special shape of the opening causes a greater repulsion force than the cylindrical opening shown in figure 1.

In both embodiments only one coil 2 is needed for both attracting the magnetic beads for sedimentation, and repelling of the magnetic beads for washing. Just only by translation of the coil or the sensor, the actual magnetic force can be switched between attractive force and repulsive force.

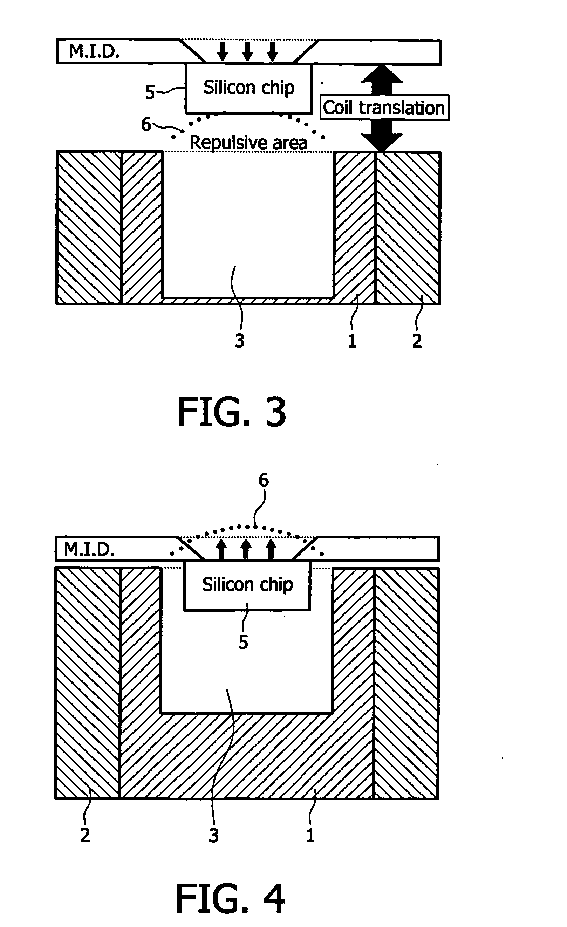

Figure 3 and figure 4 show the two end positions of the sensor-chip-movement. Fig. 3 shows the status, at which the sensor chip 5 or the coil 2 within the magnetic core 1 is mechanically translated for a defined relative distance, so that the repulsive area 6 of the magnet ends under the sensor chip 5, so that the area above the sensor chip is influenced by the attractive magnetic force. Consequently, the magnetic force in this area attracts the magnetic beads in the biomaterial in order to speed up the sedimentation of it on the sensor surface.

In figure 4 is shown the other relative end position, where the sensor chip 5 is inside the opening 3, so that the repulsive magnetic area 6 is effective above the sensor chip 5. In this position a repulsive force on the magnetic beads in the biomaterial is generated, so that it is repelled, or in other words, washed from the sensor surface quickly.

The magnitude of the magnetic force is very important for the desired effect of sedimentation and washing. The force is linear proportional to the speed of the magnetic beads and therefore also to the sedimentation time. More important is that a certain force has to be overcome in order to wash the non-specific beads from the surface. Using a second coil can boost the force.

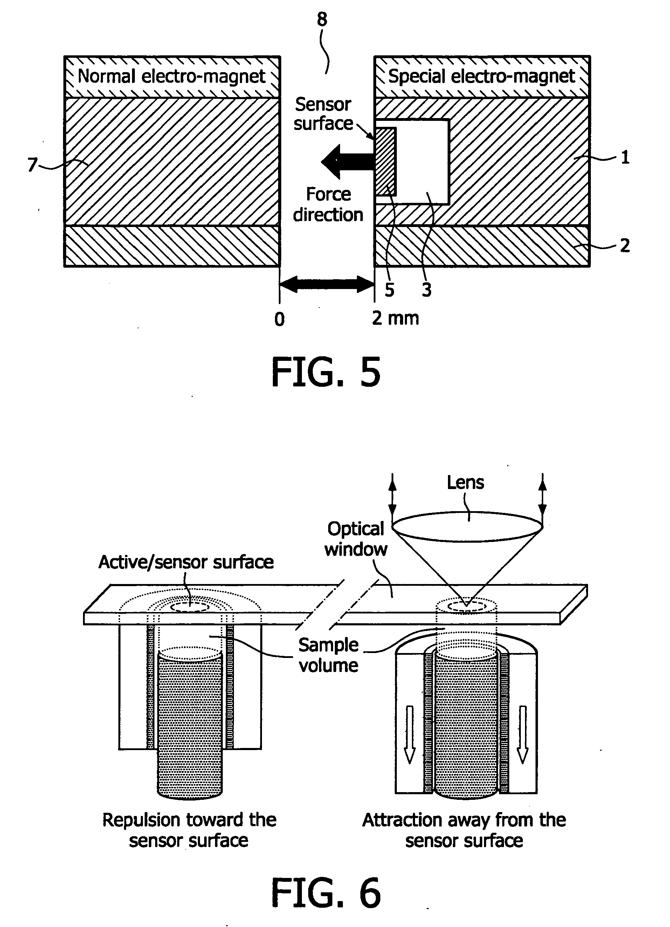

This second coil 7 is a normal coil in vicinity of the special coil 2, between which the sensor chip 5 is arranged. So the sensor or sensor chip 5 is moved inside this gap 8, or alternatively the magnet comprising the second coil 7 and the special coil 2 is translated with the same resulting effect. A configuration of such a system is shown in figure 5. The effective force, using both magnetic coils, is boosted a factor of nearly 4 compared to the system with only one coil as described above. Compared to a system that only uses a conventional coil, a boosting factor of more than 10 is achieved, the magnetic force being effective on the sensor chip 5 is enhanced by a factor of 10.

This boosting property of the system has some major benefits. Less current is needed in order to achieve the same amount of force. By this, the system can be sustained with less or even without active cooling of the coils. Less current and less active cooling saves a lot of power, which is very important for portable point-of-care applications of the biosensors.

The sensor can be any suitable sensor to detect the presence of magnetic particles on or near to a sensor surface, based on any property of the particles, e.g. it can detect via magnetic methods for example magnetoresistive methods, Hall methods, coils etc, as well as optical methods like imaging, fluorescence, chemiluminescence, absorption, scattering, surface plasmon resonance, etc. Also, sonic detection is possible , that means generation and detection of surface acoustic wave, bulk acoustic wave, cantilever, quartz crystal etc, as well as electrical detection like conduction, impedance, amperometric, redox cycling, etc. Moreover, the sensor can be any suitable magnetic sensor based on the detection of the magnetic properties of particles to be measured on or near to the sensor surface. Therefore, the magnetic sensor is designable as a coil, magneto-resistive sensor, magneto-restrictive sensor, Hall sensor, planar Hall sensor, flux gate sensor, SQUID (Semiconductor Superconducting Quantum Interference Device), magnetic resonance sensor, or as another sensor actuated by a magnetic field.

The labels can be detected directly by the sensing method. As well, the particles can be further processed prior to detection. An example of further processing is that materials are added or that the chemical, biochemical or physical properties of the label are modified to facilitate detection.

The detection can occur with or without scanning of the sensor element with respect to the biosensor surface. In addition to molecular assays, also larger moieties can be detected, e.g. cells, viruses, or fractions of cells or viruses, tissue extract, etc.

Measurement data can be derived as an end-point measurement, as well as by recording signals kinetically or intermittently.

The device and method can be used with several biochemical assay types, e.g. binding/unbinding assay, sandwich assay, competition assay, displacement assay, enzymatic assay, etc.

The device, methods and systems of this invention are suited for sensor multiplexing, for example the parallel use of different sensors and sensor surfaces, label multiplexing for example the parallel use of different types of labels, and chamber multiplexing for example the parallel use of different reaction chambers.

The device, methods and systems described in the present invention can be used as rapid, robust, and easy to use point-of-care biosensors for small sample volumes. The reaction chamber can be a disposable item to be used with a compact reader, containing the one or more magnetic field generating means and one or more detection means. Also, the device, methods and systems of the present invention can be used in automated high-throughput testing. In this case, the reaction chamber is e.g. a well plate or cuvette, fitting into an automated instrument.

Figure 6 shows optical means for the aforesaid optical or optoelectronical detection.

Optical labels offer some desirable properties:
- Many detection possibilities like imaging, fluorescence, absorption, scattering, turbidometry, SPR (Surface Plasmon Resonance), SERRS (Surface-and Resonance-Enhanced Raman Scattering), luminescence, chemiluminescence, electrochemiluminescence, FRET (Fluorescence Resonance Energy Transfer), etc.
- Imaging possibility offers high multiplexing.
- Optical labels are generally small and do not influence the assay too much.

A good combination would be to use magnetic labels that can be actuated by applying magnetic field gradients and that can be detected optically. An advantage is that optics and magnetics are orthogonal in the sense that in most cases optical beams do not show interference with magnetic fields and vice versa. This means that magnetic actuation would be ideally suited for combination with optical detection. Problems such as sensor disturbance by the actuation fields are eliminated.

The problem of combining magnetic actuation and optical detection is in the geometrical constraint. To develop a cartridge technology that is compatible with magnetic actuation means, typically an electromagnet needs to operate at a small distance between magnet and sensor surface. An optical system needs to scan the same surface, possible with high-NA (Narrow Angle) optics. The opto-mechanical set-up and the electromagnet therefore hinder each other when integrating a concept with magnetic actuation and optical detection. Preferably, a configuration with a magnet on only one side is needed. This magnet is able to generate a switchable magnetic field.

## Claims

1. A magnetic system for biosensors, with at least a coil and a ferromagnetic core generating a magnetic field, and a sensor or sensor-surface which corresponds with the magnetic field in a way, that the ferromagnetic core is equipped with an opening filling a part of the core at the side at which the sensor is located, in order to produce a local high density of inhomogeneous magnetic field lines corresponding to **essentially** opposed magnetic forces **at** the at least one coil with the core, along which the sensor is movable between at least two definable positions.

2. A magnetic system for biosensors according to claim 1, **characterized in that** the opening in the magnetic core is a cylindrical blind hole.

3. A magnetic system for biosensors according to claim 1, **characterized in that** the opening in the core is a cone shaped hole or opening.

4. A magnetic system for biosensors according to claim 2 or 3, **characterized in that** the sensor is movable between inside and outside of the opening.

5. A magnetic system for biosensors according to claim 1, **characterized in that** adjacent to the magnet a second magnet is arranged, separated over a gap, in which the position of the sensor, at least the sensor surface, is movable.

6. A magnetic system for biosensors according to one of the aforesaid claims, **characterized in that** the sensor is an array of several sensors.

7. A magnetic system for biosensors according to one of the aforesaid claims, **characterized in that** the definable end positions of the sensor movement can be optimized by a magnetic field sensor, which can be moved simultaneously with the sensor, in order to evaluate optimal extremes of the magnetic flux.

8. Method for operating a magnetic system with biosensor as described in one of the aforesaid claims, by which a sensing material or liquid is dispersed with or chemically bound to microscopic magnetic beads, and the sensor chip is moved in a close position to the opening in the magnetic core, in order to generate magnetic repulsion near the sensor surfaces area to wash the surface by repulsion forces of the magnetic beads, and the sensor chip is moved in a defined distance of the core in order to generate attraction forces to the magnetic beads for sensing the bio-substrate in a very close contact to the sensor surface.

9. Method according to claim 8, **characterized in that** the movement between sensor or sensor-chip and magnetic core is a relative movement, by which the core is moved in such a way that a first sensor position is outside of the opening in the magnetic core, thus being in the influence of the attractive force area, and one sensor position is inside the opening of the magnetic core, in the influence of the repulsive force area.

10. Method according to claim 8 or 9, **characterized in that** in a magnetic arrangement with two magnets separated by a gap, the relative position of the sensor is between the inside of the opening of one magnetic core and the inside of the gap between the two magnetic cores.

## Patentansprüche

1. Magnetisches System für Biosensoren, mit mindestens einer Spule und einem ferromagnetischen Kern zur Erzeugung eines Magnetfelds und mit einem Sensor oder einer Sensoroberfläche, der bzw. die dem Magnetfeld in einer Weise entspricht, dass der ferromagnetische Kern mit einer Öffnung versehen ist, welche einen Teil des Kerns auf der Seite, auf der sich der Sensor befindet, ausfüllt, um eine lokale hohe Dichte von inhomogenen Magnetfeldlinien zu erzeugen, die im Wesentlichen entgegengesetzten magnetischen Kräften an der mindestens einen Spule mit dem Kern entsprechen, an denen entlang der Sensor zwischen mindestens zwei definierbaren Positionen bewegbar ist.

2. Magnetisches System für Biosensoren nach Anspruch 1, **dadurch gekennzeichnet, dass** die Öffnung in dem magnetischen Kern ein zylindrisches Blindloch ist.

3. Magnetisches System für Biosensoren nach Anspruch 1, **dadurch gekennzeichnet, dass** die Öffnung in dem Kern ein konusförmiges Loch oder eine konusförmige Öffnung ist.

4. Magnetisches System für Biosensoren nach Anspruch 2 oder 3, **dadurch gekennzeichnet, dass** der Sensor zwischen innerhalb und außerhalb der Öffnung bewegbar ist.

5. Magnetisches System für Biosensoren nach Anspruch 1, **dadurch gekennzeichnet, dass** angrenzend an den Magneten ein zweiter Magnet getrennt durch einen Spalt angeordnet ist, in dem die Position des Sensors, zumindest der Sensoroberfläche, bewegbar ist.

6. Magnetisches System für Biosensoren nach einem der oben genannten Ansprüche, **dadurch gekennzeichnet, dass** der Sensor ein Array aus mehreren Sensoren ist.

7. Magnetisches System für Biosensoren nach einem der oben genannten Ansprüche, **dadurch gekennzeichnet, dass** die definierbaren Endpositionen der Sensorbewegung durch einen Magnetfeldsensor optimiert werden können, der gleichzeitig mit dem Sensor bewegt werden kann, um die optimalen Extreme des magnetischen Flusses zu evaluieren.

8. Verfahren zum Betreiben eines Magnetsystems mit Biosensor nach einem der vorhergehenden Ansprüche, durch das ein erfassendes Material oder eine erfassende Flüssigkeit mit mikroskopischen magnetischen Perlen dispergiert wird oder chemisch daran gebunden wird, und der Sensorchip in eine Position nahe der Öffnung in dem magnetischen Kern bewegt wird, um eine magnetische Abstoßung nahe des Sensoroberflächenbereichs zu erzeugen, um die Oberfläche durch Abstoßungskräfte der magnetischen Perlen zu waschen, und der Sensorchip in einen definierten Abstand des Kerns bewegt wird, um Anziehungskräfte zu den magnetischen Perlen zu erzeugen, um das Biosubstrat in einem sehr engen Kontakt zu der Sensoroberfläche zu erfassen.

9. Verfahren nach Anspruch 8, **dadurch gekennzeichnet, dass** die Bewegung zwischen Sensor oder Sensorchip und magnetischem Kern eine relative Bewegung ist, durch die der Kern auf eine derartige Weise bewegt wird, dass eine erste Sensorposition außerhalb der Öffnung in dem magnetischen Kern liegt und somit im Einflussbereich der Anziehungskraft, und eine Sensorposition innerhalb der Öffnung des magnetischen Kerns liegt und somit im Einflussbereich der Abstoßungskraft.

10. Verfahren nach Anspruch 8 oder 9, **dadurch gekennzeichnet, dass** in einer magnetischen Anordnung mit zwei durch einen Spalt getrennten Magneten die relative Position des Sensors zwischen dem Inneren der Öffnung von einem magnetischen Kern und dem Inneren des Spalts zwischen den beiden magnetischen Kernen liegt.

## Revendications

1. Système magnétique pour biocapteurs, avec au moins une bobine et un noyau ferromagnétique générant un champ magnétique, et un capteur ou une surface de capteur qui correspond au champ magnétique, de telle sorte que le noyau ferromagnétique soit équipé d'une ouverture qui remplit une partie du noyau sur le côté où le capteur est situé, afin de produire une densité localement élevée de lignes de champ magnétique hétérogène correspondant à des forces magnétiques essentiellement opposées au niveau de ladite au moins une bobine avec le noyau, le long duquel le capteur est mobile entre au moins deux positions définissables.

2. Système magnétique pour biocapteurs selon la revendication 1, **caractérisé en ce que** l'ouverture dans le noyau magnétique est un trou borgne cylindrique.

3. Système magnétique pour biocapteurs selon la revendication 1, **caractérisé en ce que** l'ouverture dans le noyau est un orifice ou une ouverture en forme de cône.

4. Système magnétique pour biocapteurs selon la revendication 2 ou 3, **caractérisé en ce que** le capteur est mobile entre l'intérieur et l'extérieur de l'ouverture.

5. Système magnétique pour biocapteurs selon la revendication 1, **caractérisé en ce qu'**un second aimant est disposé près de l'aimant, séparé par un intervalle, dans lequel la position du capteur, au moins la surface du capteur, est mobile.

6. Système magnétique pour biocapteurs selon l'une quelconque des revendications précédentes, **caractérisé en ce que** le capteur est représenté par une rangée de plusieurs capteurs.

7. Système magnétique pour biocapteurs selon l'une quelconque des revendications précédentes, **caractérisé en ce que** les positions extrêmes définissables du mouvement du capteur peuvent être optimisées par un capteur de champ magnétique, qui peut être déplacé simultanément avec le capteur, afin d'évaluer les extrêmes optimaux du flux magnétique.

8. Procédé visant à faire fonctionner un système magnétique avec un biocapteur, tel que décrit dans l'une des revendications précédentes, par lequel un matériau de détection ou liquide est dispersé avec des perles magnétiques microscopiques ou chimiquement lié à celles-ci, et la puce du capteur est déplacée dans une position proche de l'ouverture dans le noyau magnétique, afin de générer une répulsion magnétique près de la zone des surfaces du capteur, afin de laver la surface par des forces de répulsion des perles magnétiques, et la puce du capteur est déplacée sur une distance définie du noyau, afin de générer des forces d'attraction aux perles magnétiques permettant de détecter le biosubstrat en contact très étroit avec la surface du capteur.

9. Procédé selon la revendication 8, **caractérisé en ce que** le mouvement entre le capteur ou la puce du capteur et le noyau magnétique est un mouvement relatif, par lequel le noyau est déplacé de sorte qu'une première position de capteur soit située hors de l'ouverture dans le noyau magnétique, étant ainsi dans l'influence de la zone de force d'attraction, et une position de capteur soit située à l'intérieur de l'ouverture du noyau magnétique, dans l'influence de la zone de la force de répulsion.

10. Procédé selon la revendication 8 ou 9, **caractérisé en ce que**, dans une disposition magnétique avec deux aimants séparés par un intervalle, la position relative du capteur est entre l'intérieur de l'ouverture d'un noyau magnétique et l'intérieur de l'intervalle entre les deux noyaux magnétiques.
